# EUROPÄISCHE PATENTANMELDUNG

(11) **EP 2 487 501 A1**
(43) Veröffentlichungstag der Anmeldung: **15.08.2012**
(21) Anmeldenummer: 12151778.3
(22) Anmeldetag: 19.01.2012
(51) Int. Cl.: G01R 33/421, G01R 33/422, G01R 33/28

(54) **Vorrichtung zur Erzeugung von Gegenfeldern, sowie Verfahren zum Betreiben eines Magnetresonanztomographen**

(30) Priorität: 10.02.2011 US 201161441288 P
(71) Anmelder: BIOTRONIK SE & Co. KG, 12359 Berlin (DE)
(72) Erfinder: Dörr, Thomas, 12437 Berlin (DE); Weiss, Ingo, 12435 Berlin (DE)
(74) Vertreter: Lindner-Vogt, Karin L.

(57) **Zusammenfassung**

Die Erfindung betrifft eine Vorrichtung zur Erzeugung von Gegenfeldern zur Abschirmung eines Implantats im Körper einer Person bei einer magnetresonanztomographischen Aufnahme, welche eine Felderzeugungseinrichtung mit einem oder mehreren Felderzeugungsmitteln zum Erzeugen von Feldpulsen und eine mit der Felderzeugungseinrichtung gekoppelte Steuereinrichtung umfasst und so ausgebildet ist, dass Feldpulse als Gegenfelder erzeugbar sind, durch welche bei der magnetresonanztomographischen Aufnahme eingesetzte hochfrequente, elektromagnetische Feldpulse und/oder magnetische Gradientenfeldpulse in einer das Implantat zumindest abschnittsweise enthaltenden räumlichen Zone durch Superposition in ihrer Intensität verringer- oder auslöschbar sind. Sie betrifft des Weiteren ein Verfahren zum Betreiben eines Magnetresonanztomographen, bei welchem Feldpulse als Gegenfelder erzeugt werden, durch die bei einer magnetresonanztomographischen Aufnahme eingesetzte hochfrequente, elektromagnetische Feldpulse und/oder magnetische Gradientenfeldpulse in einer ein Implantat im Körper einer Person zumindest abschnittsweise enthaltenden räumlichen Zone durch Superposition in ihrer Intensität verringer- oder auslöschbar sind.

## Beschreibung

Die Erfindung liegt auf dem Gebiet der Medizintechnik und betrifft eine Vorrichtung zur Erzeugung von Gegenfeldern zur Abschirmung eines Implantats im Körper einer Person bei einer magnetresonanztomographischen Aufnahme, sowie ein Verfahren zum Betreiben eines Magnetresonanztomographen.

Bei der Kernspin- oder Magnetresonanztomographie (MRT = Magnetresonanztomographie) werden Atomkerne durch ein starkes statisches Magnetfeld (B₀-Feld) zu einer Präzessionsbewegung um die Feldrichtung gezwungen und während einer Anregungsphase durch hochfrequente elektromagnetische Feldpulse resonant angeregt. Nach Abschalten der Hochfrequenzpulse kehren die Atomkerne wieder in ihre Ausgangsrichtung zurück, wobei die Abklinkzeiten (Relaxationszeiten) charakteristisch für verschiedene Gewebsarten sind. Zeitgleich mit den Hochfrequenzpulsen werden schnell geschaltete magnetische Gradientenfelder (B₁-Feld) eingesetzt, durch die erreicht werden kann, dass das auf die Atomkerne einwirkende Magnetfeld entlang einer vorgegebenen Richtung beispielsweise linear variiert. Hierdurch wird eine Veränderung der Resonanzfrequenz bewirkt, die eine räumliche Zuordnung einzelner MRT-Signale ermöglicht.

MRT-Untersuchungen gehören mittlerweile zur täglichen Routine in der radiologischen Diagnostik, wobei unter normalen Untersuchungsbedingungen, abgesehen von gelegentlichen Befindlichkeitsstörungen, keine Gefährdung für die Patienten besteht. Allerdings besitzen immer mehr Patienten ganz oder teilweise aus einem metallischen bzw. leitfähigen Material bestehende Implantate, die Probleme bei der Untersuchung verursachen und die Patienten im schlimmsten Falle sogar verletzen können. Eine Rolle hierbei spielt das verwendete Material und die Geometrie des Implantats, sowie dessen Lage in Bezug auf die MRT-Feldpulse. So wirken manche Implantate als Antenne für die eingestrahlten MRT-Feldpulse und erwärmen sich durch die erzeugten Induktionsströme stark. In der Folge kann eine thermische Schädigung des umliegenden Gewebes auftreten. In elektronischen Implantaten, beispielsweise Herzschrittmacher, kann eine Fehlfunktion, beispielsweise ein fehlerhaftes Sensing oder ein unerwünschter Neustart mit voreingestellten Startparametern ("power-on reset"), ausgelöst werden.

Aus diesem Grund muss der diagnostische Nutzen einer MRT-Untersuchung gegenüber dem Risiko nachteiliger Nebenwirkungen sorgfältig abgewogen werden. Erschwerend kommt hinzu, dass die Erwärmung mancher Implantate von den spezifischen Scan-Parametern und insbesondere von deren Positionierung relativ zu den MRT-Feldpulsen abhängt, so dass in der klinischen Praxis oftmals keine verlässlichen Vorhersagen über die zu erwartenden Auswirkungen getroffen werden können. All dies führt dazu, dass Patienten mit einem Implantat in der Regel von der an sich schonenden Untersuchung mittels MRT ausgeschlossen sind.

In jüngster Zeit wurden vermehrt Anstrengungen unternommen, dieses Problem zu lösen. So wurden beispielsweise neue Herzschrittmachersysteme entwickelt, die über geometrisch speziell gestaltete Schrittmacherelektroden verfügen, um einer Erwärmung durch die Wechselfelder entgegen zu wirken. Ebenso werden speziell konstruierte Herzschrittmacher im Handel vertrieben, die für eine Untersuchung in einem Magnetresonanztomographen zugelassen sind. Nachteilig hierbei ist, dass diese Lösungen mit einem zusätzlichen Kostenaufwand für die Implantate und gegebenenfalls auch mit einer Beeinträchtigung der Implantateigenschaften verbunden sind. Zudem können Implantatträger mit Implantaten ohne spezielle Eignung weiterhin nicht mittels MRT untersucht werden.

Demgegenüber besteht die Aufgabe der vorliegenden Erfindung darin, Träger herkömmlicher, nicht speziell für die MRT zugelassener Implantate gefährdungslos einer magnetresonanztomographischen Untersuchung zuführen zu können. Diese und weitere Aufgaben werden nach dem Vorschlag der Erfindung durch eine Vorrichtung zur Erzeugung von Gegenfeldern, sowie ein Verfahren zum Betreiben eines Magnetresonanztomographen mit den Merkmalen der nebengeordneten Patentansprüche gelöst. Vorteilhafte Ausgestaltungen der Erfindung sind durch die Merkmale der Unteransprüche angegeben.

Erfindungsgemäß ist eine Vorrichtung zur Erzeugung von Gegenfeldern gezeigt, die zur Abschirmung eines zumindest teilweise aus einem metallischen bzw. leitfähigen Material bestehenden Implantats im Körper einer Person von bei einer magnetresonanztomographischen Aufnahme eingesetzten Feldpulsen (MRT-Feldpulsen) dient. Durch die abschirmende Wirkung der erfindungsgemäßen Vorrichtung kann eine elektromagnetische Interferenz zwischen den MRT-Feldpulsen und dem Implantat verringert bzw. verhindert werden. Wie eingangs bereits ausgeführt wurde, werden bei einer magnetresonanztomographischen Aufnahme elektromagnetische Hochfrequenzpulse zur Anregung der präzedierenden Atomkerne und schnell geschaltete magnetische Gradientenfelder zur räumlichen Zuordnung der empfangenen MRT-Signale eingesetzt. Im Sinne vorliegender Erfindung sind unter dem Begriff "Feldpulse" gepulste (d.h. zeitlich geschaltete) hochfrequente elektromagnetische Wechselfelder und gepulste magnetische Gradientenfelder zu verstehen. Bei den Hochfrequenzpulsen handelt es sich in der Regel um Felder, deren Frequenz in einem Frequenzbereich oberhalb von 1 MHz liegt. Beispielsweise können Protonen in einem statischen Magnetfeld von 1 Tesla mit einem elektromagnetischen Wechselfeld einer Frequenz von ca. 42 MHz, in einem statischen Magnetfeld von 1,5 Tesla mit einem elektromagnetischen Wechselfeld einer Frequenz von ca. 63 MHz, angeregt werden.

Die erfindungsgemäße Vorrichtung zur Erzeugung von Gegenfeldern dient zur Abschirmung von Implantaten, wobei es sich bei den Implantatträgern um Patienten, an denen eine MRT-Untersuchung vorgenommen wird, aber auch um medizinisch-technische Assistenten oder Ärzte, welche eine MRT-Untersuchung durchführen und dabei gegebenenfalls MRT-Feldpulsen ausgesetzt sind, handeln kann.

Im Sinne vorliegender Erfindung ist der Ausdruck "Implantat" breit zu verstehen. In allgemeiner Weise bezeichnet er eine für einen dauerhaften oder vorübergehenden Verbleib im Körper vorgesehene Vorrichtung, bei der er sich beispielsweise um ein elektronisches Gerät, wie einen Herzschrittmacher oder Kardiokonverter, eine Elektrode, wie eine Stimulationselektrode, insbesondere zur Nervenstimulation, eine Herzschrittmacherelektrode, eine ICD-Elektrode, einen Elektrophysiologie-Katheter oder eine Elektrode zur Messung von Hirnpotentialen oder dergleichen handeln kann. Es versteht sich, dass diese Aufzählung nicht abschließend ist.

Die erfindungsgemäße Vorrichtung zur Erzeugung von Gegenfeldern umfasst eine Felderzeugungseinrichtung mit einem oder mehreren Felderzeugungsmitteln zum Erzeugen von als Gegenfelder dienenden Feldpulsen. Die Felderzeugungseinrichtung kann zu diesem Zweck über einen mit den Felderzeugungsmitteln gekoppelten Signalgenerator zum Erzeugen elektrischer Signale verfügen. Die Felderzeugungsmittel können beispielsweise in Form von Antennen, insbesondere Dipolfeld-Antennen, Resonatoren, insbesondere Birdcage-Resonatoren, die beispielsweise als Hochpass-, Tiefpass-, oder Bandpassfilter ausgebildet sein können, und Spulen, insbesondere Flach-, Helmholtz-, Maxwellspulen, Solenoide oder Sattelspulen, ausgebildet sein. Die erfindungsgemäße Vorrichtung zur Erzeugung von Gegenfeldern umfasst weiterhin eine mit der Felderzeugungseinrichtung gekoppelte Steuereinrichtung.

Wesentlich hierbei ist, dass die Vorrichtung zur Erzeugung von Gegenfeldern so ausgebildet ist, dass Feldpulse als Gegenfelder erzeugbar sind, durch welche bei der MRT-Aufnahme eingesetzte hochfrequente, elektromagnetische Feldpulse und/oder magnetische Gradientenfeldpulse in einer das Implantat zumindest abschnittsweise enthaltenden räumlichen Zone durch Superposition (Überlagerung) in ihrer Intensität verringer- oder auslöschbar sind. Insbesondere ist die Steuereinrichtung zu diesem Zweck programmtechnisch entsprechend eingerichtet. Als "Abschirmung" ist im Sinne vorliegender Erfindung somit keine passive Abschirmung durch ein elektrisch leitfähiges Material (Dämpfung) sondern eine durch Superposition bewirkte aktive Abschirmung unter Energieverbrauch zu verstehen.

Unter dem Begriff "Gegenfeld" ist hier und im Weiteren ein Feld zu verstehen, das geeignet ist, durch Superposition zumindest eine Intensitätsverringerung eines MRT-Feldpulses zu bewirken, wobei Gegenphasigkeit und Amplitudengleichheit nicht zwingend erforderlich sind. Die Felderzeugungsmittel können von einem Signalgenerator, insbesondere mit nachgeschaltetem Verstärker, gespeist werden. Insbesondere können die Felderzeugungsmittel auch von einem Magnetresonanztomographen selbst angesteuert werden. In diesem Fall kann die Steuereinrichtung Teil des Magnetresonanztomographen sein.

Die erfindungsgemäße Vorrichtung zur Erzeugung von Gegenfeldern ermöglicht somit in vorteilhafter Weise eine einfache, kostengünstige und für Implantatträger gefährdungsfreie MRT-Untersuchung, ohne dass spezielle Vorkehrungen an den Implantaten zu treffen sind. Elektromagnetische Interferenzen zwischen den Feldpulsen und den Implantaten können zuverlässig und sicher vermieden werden. Insbesondere können mithilfe der erfindungsgemäßen Vorrichtung auch Träger herkömmlicher Implantate, insbesondere Personen mit einer defekten und/oder stillgelegten Elektrode oder Sonde, einer MRT-Untersuchung zugeführt werden. Neben Patienten kann die erfindungsgemäße Vorrichtung zum Erzeugen von Gegenfeldern auch zum Schutz von medizinischem Personal verwendet werden.

Durch die Vorrichtung zur Erzeugung von Gegenfeldern soll eine abschirmende Wirkung erreicht werden, die jedenfalls so stark ist, dass eine mit einer möglichen Gefährdung des Implantatträgers einher gehende Beeinträchtigung des Implantats verhindert wird. Insbesondere soll eine mögliche Fehlfunktion eines elektronischen Implantats verhindert und die Erwärmung einer Elektrode stark reduziert werden. Ohne hierauf eingeschränkt zu sein, kann die Vorrichtung zur Erzeugung vom Gegenfeldern so ausgebildet sein, dass die Intensität von MRT-Feldpulsen, bezogen auf die Intensität der MRT-Feldpulse vor der Superposition mit den Gegenfeldern, kleiner als 50%, insbesondere kleiner als 40%, insbesondere kleiner als 30%, insbesondere kleiner als 20%, insbesondere kleiner als 10%, insbesondere kleiner als 5% und insbesondere kleiner als 1% ist.

Die erfindungsgemäße Vorrichtung kann so ausgebildet sein, dass Feldpulse als Gegenfelder erzeugt werden, derart, dass
a) ausschließlich die elektromagnetischen Hochfrequenzpulse in ihrer Intensität verringert oder ausgelöscht werden, während die magnetischen Gradientenfeldpulse ohne Gegenfeld ungehindert zum Implantat passieren können;
b) ausschließlich die magnetischen Gradientenfeldpulse in ihrer Intensität verringert oder ausgelöscht werden, während die elektromagnetischen Hochfrequenzpulse ohne Gegenfeld ungehindert zum Implantat passieren können;
c) sowohl die elektromagnetischen Hochfrequenzpulse als auch die magnetischen Gradientenfeldpulse jeweils in ihrer Intensität verringert oder ausgelöscht werden.

Insbesondere kann die erfindungsgemäße Vorrichtung so ausgebildet sein, dass nur die unerwünschten (z.B. Elektroden erwärmenden) hochfrequenten Wechselfelder reduziert oder günstig umverteilt werden, während die magnetischen Gradientenfelder im Hinblick auf eine gute Bildgebung möglichst wenig beeinträchtigt werden. Dieser Effekt kann beispielsweise über eine Steuerung von Amplituden und Phasenlagen der als Gegenfelder dienenden Feldpulse realisiert werden. Für den Fall, dass Körperbereiche, die nicht geschützt werden sollen, einer höheren Feldbelastung ausgesetzt sind als ohne Anwendung der erfindungsgemäßen Vorrichtung, ist die Vorrichtung vorteilhaft so ausgebildet, dass zulässige Normgrenzen nicht überschritten werden. Dies kann insbesondere zugunsten der Körperregion erfolgen, die geschützt werden soll (Feldumverteilung).

Bei einer vorteilhaften Ausführungsform der erfindungsgemäßen Vorrichtung zur Erzeugung von Gegenfeldern ist diese so ausgebildet, dass die als Feldpulse erzeugten Gegenfelder bezüglich Frequenzen, Amplituden und Phasen an die Feldpulse eines bestimmten Scanner-Typs (Magnetresonanztomographen) wahlfrei angepasst oder anpassbar sind. Die Gegenfelder können insbesondere spezifisch auf Magnetresonanztomographen mit statischen Magnetfeldern im Bereich von 1 bis 7 Tesla angepasst sein. Die Vorrichtung zur Erzeugung von Gegenfeldern ist dann für bestimmte Scanner-Typen besonders wirksam.

Bei einer weiteren vorteilhaften Ausführungsform der erfindungsgemäßen Vorrichtung zur Erzeugung von Gegenfeldern ist diese so ausgebildet, dass die erzeugten Gegenfelder nur für einen bestimmten Frequenzbereich, insbesondere ein Frequenzbereich oberhalb von 1 MHz, wirksam sind. Die Vorrichtung ist somit für die magnetischen Gradientenfelder transparent und verzerrt diese nicht. Damit kann näher am geschützten Bereich eine Bildgebung erfolgen (Reduktion der Bildartefakte). Alternativ ist es möglich, dass die erzeugten Gegenfelder nur für einen Frequenzbereich von maximal 1 MHz wirksam sind. Die Vorrichtung ist somit für die magnetischen Gradientenfelder wirksam und für die hochfrequenten elektromagnetischen Wechselfelder transparent und verzerrt diese nicht.

Bei einer weiteren vorteilhaften Ausführungsform der erfindungsgemäßen Vorrichtung zur Erzeugung von Gegenfeldern ist diese so ausgebildet, dass die Gegenfelder nur während der Anregungsphase, d. h. während der Phase der Erzeugung von Hochfrequenzpulsen und magnetischen Gradientenfelder, insbesondere während deren Flanken, erzeugt werden, nicht jedoch während der Auslesephase der Bilderfassung. Durch diese Maßnahme kann die anregende Energie gedämpft werden, um beispielsweise eine Elektrodenerwärmung zu minimieren. Andererseits können die von den Atomkernen zurückgesandten MRT-Signale ohne Reduktion erfasst werden, so dass die Bildqualität insbesondere in der abgeschirmten bzw. geschützten Körperregion nicht beeinträchtigt ist.

Bei einer weiteren vorteilhaften Ausführungsform der erfindungsgemäßen Vorrichtung zur Erzeugung von Gegenfeldern ist diese so ausgebildet, dass sie als Link bzw. Bindeglied zwischen einer herkömmlichen Programmiereinrichtung, die sich typischer Weise außerhalb des Magnetresonanztomographen bzw. eines diesen enthaltenden Raums befindet, und dem Implantat dient. Zu diesem Zweck sie so ausgebildet sein, dass die Signale zur Kommunikation mit dem Implantat bei einer Frequenz bzw. in einem Frequenzbereich gesendet und empfangen werden, die von den Frequenzen der Feldpulse einer MRT-Aufnahme verschieden sind. Die Signale können insbesondere durch die Felderzeugungseinrichtung abgegeben werden, wobei das zumindest eine Felderzeugungsmittel als lokaler Programmierkopf für das Implantat dienen kann. Insbesondere können auch optische und/oder akustische Signale für eine Kommunikation mit dem Implantat eingesetzt werden. Vorteilhaft ist die Vorrichtung so eingerichtet, dass eine Kommunikation zwischen Link und Implantat nur in Zeitabschnitten erfolgt, in denen keine MRT-Feldpulse ausgesendet werden. Insbesondere ist demnach auch in den Pausen zwischen den zur Bildgebung eingesetzten MRT-Feldpulsen eine Programmierung des Implantats möglich.

Bei einer weiteren vorteilhaften Ausführungsform der erfindungsgemäßen Vorrichtung zur Erzeugung von Gegenfeldern umfasst sie einen oder mehrere Sensoren zum Erfassen von bei der MRT-Aufnahme eingesetzten MRT-Feldpulsen und Erzeugen entsprechender Sensorsignale, wobei die Vorrichtung so eingerichtet ist, dass Feldpulse als Gegenfelder auf Basis von Sensorsignalen erzeugbar sind. Die Gegenfelder können somit gezielt im Hinblick auf lokal applizierte MRT-Feldpulse erzeugt werden, so dass das Implantat besonders effektiv abgeschirmt werden kann. Von Vorteil kann es sein, wenn der Sensor innerhalb der das Implantat enthaltenden räumlichen Zone anordenbar ist, so dass die in dieser Zone applizierten MRT-Feldpulse erfasst werden können. Eine Anpassung der erzeugten Gegenfelder an die applizierten MRT-Feldpulse erfolgt vorteilhaft in einer Regelschleife, wobei ein oder mehrere Sensoren beispielsweise so ausgebildet sein können, dass Sollwerte (insbesondere Feldausgleich zu Null) einstellbar sind. Insbesondere können zu diesem Zweck PLL-Schaltungen (PLL = Phase Locked Loop) eingesetzt werden.

Bei einer weiteren vorteilhaften Ausführungsform der erfindungsgemäßen Vorrichtung zur Erzeugung von Gegenfeldern ist diese so ausgebildet, dass die als Gegenfelder erzeugten Feldpulse eine magnetresonanztomographische Bildgebung in einem vorbestimmbaren Maximalabstand von der zu schützenden Körperregion (d. h. in der das Implantat zumindest abschnittsweise enthaltenden räumlichen Zone) möglich ist. Vorteilhaft ist eine Bildgebung bereits in einem Abstand von weniger als 3 cm von der zu schützenden Körperregion möglich.

In der erfindungsgemäßen Vorrichtung zur Erzeugung von Gegenfeldern kann es weiterhin von Vorteil sein, wenn die erzeugten Gegenfelder eine magnetresonanztomographische Bildgebung auch im Wirkbereich der Vorrichtung, d. h. in der zu schützenden Körperregion ermöglichen. Vorzugsweise ist eine Bildgebung wenigstens bis zu 10 cm in die das Implantat zumindest abschnittsweise enthaltende räumliche Zone hinein möglich. Ferner kann es von Vorteil sein, dass ein durch Einsatz der Gegenfelder bewirkter reduzierter spezifischer Absorptionswert (SAR-Wert) so groß ist, dass eine eingeschränkte Bildgebung noch möglich ist.

Bei einer weiteren vorteilhaften Ausführungsform der erfindungsgemäßen Vorrichtung zur Erzeugung von Gegenfeldern ist diese so ausgebildet, dass durch die erzeugten Gegenfelder nur elektronische Bauteile des Implantats geschützt werden. Auf diese Weise kann das Einkoppeln insbesondere der magnetischen Gradientenfelder in eine Programmierspule und/oder einen Transformer und/oder Leiterschleifen am Layout und/oder andere induktiv, elektrisch leitende oder magnetische Bauteile gezielt reduziert werden. Beispielsweise kann die räumliche Zone eine Kugel mit einem Radius von 10 cm sein (3 dB Grenze).

Bei einer weiteren vorteilhaften Ausführungsform der erfindungsgemäßen Vorrichtung zur Erzeugung von Gegenfeldern ist die Felderzeugungseinrichtung beispielsweise als Konstruktion mehrerer Antennen und/oder Spulen, bestehend aus leitfähigen Werkstoffen wie Metall, leitfähige Kunststoffe, Kohlefaser usw. und Kombinationen hieraus, ausgebildet.

Bei einer weiteren vorteilhaften Ausführungsform der erfindungsgemäßen Vorrichtung zur Erzeugung von Gegenfeldern ist zumindest die Felderzeugungseinrichtung so ausgebildet, dass sie vorübergehend am oder nahe dem Körper der Person angeordnet werden kann. Insbesondere kann zu diesem Zweck auch die Vorrichtung zur Erzeugung von Gegenfeldern als solche in dieser Weise ausgebildet sein. Durch diese Maßnahme kann eine besonders effektive Abschirmung des Implantats vor den MRT-Feldpulsen erreicht werden. Um die Felderzeugungseinrichtung oder Vorrichtung zur Erzeugung von Gegenfeldern vorübergehend am oder nahe dem Körper der Person anbringen zu können, ist sie vorteilhaft in Form einer (z. B. geschlossenen) Weste, Hose, Hosenbein, Halskrause, Kappe, Kopfmaske mit Öffnungen für Augen und Atemöffnungen oder als ein um den Körper oder ein Körperteil wickelbares Teil ausgebildet. Als Weste ausgebildet, dient sie insbesondere zur Abschirmung eines Implantats im thorakalen Bereich, beispielsweise ein Herzschrittmacher. Als Hose oder Hosenbein dient sie insbesondere zur Abschirmung einer langgestreckten metallischen Gefäßprothese bzw. Stent, die häufig eine Länge von wenigstens 200 mm aufweisen. Als Kappe bzw. Kopfmaske dient sie insbesondere zur Abschirmung eines so genannten Deep Brain Stimulators.

Insbesondere kann es dabei von Vorteil sein, wenn die Vorrichtung zur Erzeugung von Gegenfeldern oder Felderzeugungseinrichtung zur Anpassung an eine Kontur einer Körperoberfläche des Implantatträgers geeignet ausgebildet ist. Durch diese Maßnahme kann einerseits eine besonders gute Abschirmung des Implantats von den MRT-Feldpulsen erreicht werden. Andererseits erhöht sich hierdurch der Komfort für den Implantatträger. Die Felderzeugungseinrichtung oder Vorrichtung zur Erzeugung von Gegenfeldern kann zu diesem Zweck beispielsweise aus flexiblen bzw. biegsamen Materialien gefertigt sein.

Vorzugsweise ist die Felderzeugungseinrichtung oder Vorrichtung zur Erzeugung von Gegenfeldern so ausgebildet, dass ein (kürzester) Abstand zur Körperoberfläche an jeder Stelle nicht größer als 5 cm, stärker bevorzugt nicht größer als 3 cm und noch stärker bevorzugt nicht größer als 1 cm ist. Durch diese Maßnahme kann ein besonders guter abschirmender Effekt für die MRT-Feldpulse erzielt werden. Insbesondere kann die Felderzeugungseinrichtung oder Vorrichtung zur Erzeugung von Gegenfeldern auch auf eine zum Implantat benachbarte Körperoberfläche gelegt werden.

Bei einer Anwendung im thorakalen Bereich ist es bevorzugt, wenn die Flexibilität der Felderzeugungseinrichtung oder Vorrichtung zur Erzeugung von Gegenfeldern dergestalt ausgebildet ist, dass die Atmung des Implantatträgers nicht nennenswert beeinträchtigt ist. Zudem kann sie zumindest teilweise aus atmungsaktiven Materialien bestehen. Andererseits kann die Felderzeugungseinrichtung oder Vorrichtung zur Erzeugung von Gegenfeldern zur Anpassung an die Kontur der Körperoberfläche des Implantatträgers mit einem gasförmigen und/oder flüssigen Fluid befüllbar sein. Bei dem flüssigen Fluid kann es sich insbesondere um ein Gel handeln.

Die Felderzeugungseinrichtung oder Vorrichtung zur Erzeugung von Gegenfeldern kann für eine Befestigung am Körper beispielsweise mit Verschlüssen wie Klettverschlüssen versehen sein. Denkbar ist auch, sie mit einer oder mehreren Klebstellen zu versehen, so dass sie zur Fixierung auf die Körperoberfläche aufklebbar ist. Allgemein kann die Felderzeugungseinrichtung oder Vorrichtung zur Erzeugung von Gegenfeldern zum ein- oder mehrmaligen Gebrauch vorgesehen sein. Als Einmalartikel kann sie insbesondere aufklebbar ausgebildet sein.

Die Vorrichtung zur Erzeugung von Gegenfeldern ist für die in der Magnetresonanztomographie genutzten hochfrequenten elektromagnetischen Wechselfelder und die schnell geschalteten magnetischen Gradientenfelder abschirmend wirksam. Bei einer vorteilhaften Ausführungsform der erfindungsgemäßen Vorrichtung weist sie oder die Felderzeugungseinrichtung eine relative magnetische Permeabilität von maximal 100, insbesondere von maximal 4, insbesondere von maximal 1 auf. Die relative magnetische Permeabilität kann beispielsweise im Bereich 4 bis 100 liegen. Dabei kann es von Vorteil sein, wenn die Felderzeugungseinrichtung oder Vorrichtung zur Erzeugung von Gegenfeldern im Wesentlichen nur aus para- und/oder diamagnetischen bzw. magnetisch neutralen Materialien besteht. Durch diese Maßnahme kann erreicht werden, dass sie für die in der MRT-Untersuchung verwendeten starken statischen Magnetfelder und magnetischen Gradientenfelder transparent ist, um eine Verzerrung dieser Felder zur Artefaktverminderung zu vermeiden.

Die erfindungsgemäße Vorrichtung zur Erzeugung von Gegenfeldern, insbesondere die Felderzeugungseinrichtung zur Erzeugung der Feldpulse, kann sich aufgrund von durch die MRT-Feldpulse erzeugten Induktionsströmen erwärmen. Vorzugsweise weist die Vorrichtung zur Erzeugung von Gegenfeldern eine Kühleinrichtung zu deren aktiven oder passiven Kühlung auf. Durch diese Maßnahme kann in vorteilhafter Weise einerseits der Komfort für den Implantatträger verbessert werden. Andererseits kann die Zeitdauer der MRT-Untersuchung und gegebenenfalls die Intensität der MRT-Feldpulse erhöht werden. Die Kühleinrichtung kann insbesondere als Vorrichtung zur aktiven Belüftung ausgebildet sein. Denkbar wäre auch, zum Zwecke einer aktiven Kühlung auf dem Peltier-Effekt basierende Peltier-Elemente einzusetzen, welche je nach Polung der angelegten Spannung Wärme erzeugen oder abführen können. Eine passive Kühlung kann beispielsweise durch Kühlakkus erreicht werden.

Bei einer weiteren vorteilhaften Ausführungsform der erfindungsgemäßen Vorrichtung zur Erzeugung von Gegenfeldern verfügt sie über eine Kommunikationseinrichtung zur Kommunikation mit einem elektronischen Implantat. Auf diese Weise können dem Implantat Informationen übermittelt werden, insbesondere im Hinblick auf eine bevorstehende MRT-Aufnahme. Das Implantat kann beispielsweise so programmiert sein oder werden, dass es in einen Betriebsmodus schaltet, der zur Vermeidung von Fehlfunktionen an die Bedingungen einer MRT-Aufnahme speziell angepasst ist.

Vorzugsweise verfügt die Vorrichtung zur Erzeugung von Gegenfeldern über eine autarke Energieversorgung, die in Form von Mitteln zur Erzeugung und gegebenenfalls Speicherung von Energie aus MRT-Feldpulsen realisiert sein kann. Insbesondere kann die Vorrichtung so eingerichtet sein, dass die Kommunikationseinrichtung durch Energie aus den MRT-Feldpulsen gespeist wird, so dass sie nur dann arbeitet, wenn eine MRT-Untersuchung durchgeführt wird. Die Aktivität der Kommunikationseinrichtung wird somit durch Energie der Feldpulse gesteuert, wobei das Implantat beispielsweise nur dann in einen besonderen MRT-Betriebsmodus schaltet, wenn die MRT-Aufnahme tatsächlich stattfindet und durch das Fortführen der Bildsequenz kontinuierlich am Laufen gehalten wird. Andererseits erhält das Implantat bei fehlender Aktivität der Kommunikationseinrichtung die Information, dass die MRT-Bildgebung beendet ist und somit wieder in den normalen Betriebsmodus schalten kann. Insbesondere kann die Vorrichtung zur Erzeugung von Gegenfeldern ausschließlich durch Energie aus den MRT-Feldpulsen gespeist werden.

Bei einer weiteren vorteilhaften Ausführungsform der erfindungsgemäßen Vorrichtung zur Erzeugung von Gegenfeldern weist sie eine Markierungseinrichtung zur Markierung der abgeschirmten räumlichen Zone in einer magnetresonanztomographischen Aufnahme auf. Durch diese Maßnahme kann in vorteilhafter Weise eine automatische Bildkorrektur bzw. Artefaktabgrenzung erfolgen, um auf diese Weise die Qualität der Bilderzeugung zu verbessern. Die Markierungseinrichtung kann insbesondere als RFID-Transponder (RFID = Radio-frequency identification) ausgebildet sein, der eine automatische Identifizierung und Markierung mittels elektromagnetischer Wellen ermöglicht.

Bei einer weiteren vorteilhaften Ausführungsform der erfindungsgemäßen Vorrichtung zur Erzeugung von Gegenfeldern ist diese oder lediglich die Felderzeugungseinrichtung so ausgebildet, dass sich deren Dicke (Abmessung senkrecht zu einer Körperoberfläche des Implantatträgers) aufgrund einer mechanischen Krafteinwirkung, beispielsweise durch das Gewicht der Person, wenn überhaupt, nur geringfügig ändert. Vorzugsweise erfolgt dabei eine Dickenänderung die geringer als 20% ist. Die Vorrichtung zur Erzeugung von Gegenfeldern oder Felderzeugungseinrichtung kann zu diesem Zweck beispielsweise mit einer Wabenstruktur versehen sein.

Bei einer weiteren vorteilhaften Ausführungsform der erfindungsgemäßen Vorrichtung zur Erzeugung von Gegenfeldern ist ein Randbereich (Saum) der Vorrichtung oder ein Randbereich der Felderzeugungseinrichtung so ausgebildet, dass eine übermäßige Erwärmung des Körpergewebes durch einen lokal erhöhten spezifischen Absorptionswert (SAR) vermieden wird. Dies kann beispielsweise dadurch erreicht werden, dass die Abschirmeffizienz für MRT-Feldpulse zum Rand hin beispielsweise graduell abnimmt und/oder dass ein (kürzester) Abstand zur Körperoberfläche zum Rand hin zunimmt. Durch diese Maßnahme kann der Komfort für den Implantatträger verbessert werden. Andererseits kann die Zeitdauer der Untersuchung und gegebenenfalls die Intensität der MRT-Feldpulse erhöht werden.

Bei einer weiteren vorteilhaften Ausführungsform der erfindungsgemäßen Vorrichtung zur Erzeugung von Gegenfeldern ist ein Randbereich (Saum) der Vorrichtung oder ein Randbereich der Felderzeugungseinrichtung so ausgebildet, dass sich eine Wellenimpedanz der insbesondere hochfrequenten MRT-Feldpulse vom nicht-abgeschirmten Körpergewebe zum abgeschirmten Bereich hin nur geringfügig ändert. Vorzugsweise ändert sich die Wellenimpedanz um weniger als 20%, besonders bevorzugt um weniger als 10% und noch stärker bevorzugt um weniger als 5%. Besonders bevorzugt findet eine Transformation bzw. Anpassung des Wellenwiderstands an den abgeschirmten Bereich innerhalb der ersten 2 bis 5 cm, ausgehend vom Randbereich (Saum) der Vorrichtung zur Erzeugung von Gegenfeldern oder Felderzeugungseinrichtung statt. Durch diese Maßnahme kann in vorteilhafter Weise die Qualität der Bildgebung verbessert werden.

Bei einer weiteren vorteilhaften Ausführungsform der erfindungsgemäßen Vorrichtung zur Erzeugung von Gegenfeldern ist diese, insbesondere die Felderzeugungseinrichtung, zur Anwendung im thorakalen Bereich mit Elektrodenflächen versehen, die in elektrischen Kontakt mit der Körperoberfläche bringbar sind. Die Elektrodenflächen können insbesondere zur Defibrillation verwendet werden. Vorzugsweise sind die Elektrodenflächen mit Zuleitungen derart verbunden, dass sie von einem externen Defibrillator ohne vorheriges Ablegen der Vorrichtung zur Erzeugung von Gegenfeldern, insbesondere der Felderzeugungseinrichtung, angesteuert werden können. Dies bedeutet, dass beispielsweise bei einer westenförmigen Vorrichtung zur Erzeugung von Gegenfeldern oder Felderzeugungseinrichtung Anschlüsse oder Auflageflächen zum Anschließen des Defibrillators in vorteilhafter Weise auf der Außenseite der Weste angeordnet sein können.

Bei einer weiteren vorteilhaften Ausführungsform der erfindungsgemäßen Vorrichtung zur Erzeugung von Gegenfeldern ist diese, insbesondere die Felderzeugungseinrichtung, so ausgebildet, dass sie mit der Körperoberfläche galvanisch und/oder kapazitiv koppelbar ist. Eine solche Koppelung kann beispielsweise über ein elektrisch leitfähiges Gel erfolgen. Insbesondere kann sie galvanisch getrennt und gleichzeitig kapazitiv gekoppelt sein. Im Fall einer flächig-kapazitiven Kopplung kann es von Vorteil sein, wenn die Kapazität größer als 1 pF/m² Koppelfläche ist.

Bei einer weiteren vorteilhaften Ausgestaltung der erfindungsgemäßen Vorrichtung ist die Felderzeugungseinrichtung und/oder das zumindest eine Felderzeugungsmittel zylindrisch ausgebildet und koaxial zu einer Feldspule des Magnetresonanztomographen angeordnet.

Die Erfindung erstreckt sich weiterhin auf ein Verfahren zum Betreiben eines Magnetresonanztomographen, bei welchem Feldpulse durch eine Vorrichtung zur Erzeugung von Gegenfeldern, welche eine Felderzeugungseinrichtung mit mindestens einem Felderzeugungsmittel zur Erzeugung von Feldpulsen umfasst, erzeugt werden. Die Gegenfelder sind so ausgebildet, dass bei einer MRT-Aufnahme eingesetzte elektromagnetische Hochfrequenzpulse und/oder magnetische Gradientenfeldpulse in einer ein Implantat im Körper einer Person zumindest abschnittsweise enthaltenden räumlichen Zone durch Superposition in ihrer Intensität verringer- oder auslöschbar sind. Hierbei kann es von Vorteil sein, wenn bei einer magnetresonanztomographischen Aufnahme eingesetzte Feldpulse durch zumindest einen Sensor erfasst und Feldpulse als Gegenfelder auf Basis von Sensorsignalen erzeugt werden.

Bei einer vorteilhaften Ausführungsform des erfindungsgemäßen Verfahrens wird die Vorrichtung zur Erzeugung von Gegenfeldern, insbesondere die Felderzeugungseinrichtung zur Erzeugung von als Gegenfeldern dienenden Feldpulsen, am oder nahe dem Körper der Person angebracht.

Bei einer weiteren vorteilhaften Ausführungsform des erfindungsgemäßen Verfahrens werden Feldpulse als Gegenfelder nur während einer Anregungsphase der magnetresonanztomographischen Aufnahme, in der Atomkerne resonant angeregt werden, erzeugt und somit während einer Auslesephase, in der Atomkerne relaxieren, nicht erzeugt. Somit wird die anregende Energie abgeschirmt, um das Implantat nicht zu beeinflussen, anschließend aber frei geschaltet, um das von den Atomkernen zurückgesandte MRT-Signal nicht zu reduzieren und damit die Bildqualität insbesondere im abschirmten Körperbereich nicht unnötig zu beeinträchtigen.

Bei einer weiteren vorteilhaften Ausführungsform des erfindungsgemäßen Verfahrens wird die Intensität von MRT-Feldpulsen so verringert, dass eine magnetresonanztomographische Aufnahme in der das Implantat enthaltenden räumlichen Zone zumindest bereichsweise möglich ist.

Bei einer weiteren vorteilhaften Ausführungsform des erfindungsgemäßen Verfahrens wird das Implantat vor und/oder während einer magnetresonanztomographischen Aufnahme in einen spezifisch angepassten Betriebsmodus versetzt.

Bei einer vorteilhaften Ausführungsform des erfindungsgemäßen Verfahrens wird die Vorrichtung zum Erzeugen von Gegenfeldern, insbesondere die Felderzeugungseinrichtung, zumindest zeitweilig vor und/oder während einer MRT-Aufnahme gekühlt.

Bei einer weiteren vorteilhaften Ausführungsform des erfindungsgemäßen Verfahrens werden Scan-Parameter bei einer MRT-Aufnahme wie Intensität, Frequenz und Scan-Bereich angepasst, wenn das Implantat von den MRT-Feldpulsen abgeschirmt wird, so dass eine optimierte Bildgebung ermöglicht ist.

Bei einer weiteren vorteilhaften Ausführungsform des erfindungsgemäßen Verfahrens wird die Erzeugung von Feldpulsen als Gegenfelder für die MRT-Feldpulse durch den Magnetresonanztomographen gesteuert.

Bei weiteren vorteilhaften Ausführungsformen des erfindungsgemäßen Verfahrens werden Feldpulse als Gegenfelder derart erzeugt, dass
a) ausschließlich die elektromagnetischen Hochfrequenzpulse in ihrer Intensität verringert oder ausgelöscht werden, während die magnetischen Gradientenfeldpulse ohne Gegenfeld ungehindert zum Implantat passieren können;
b) ausschließlich die magnetischen Gradientenfeldpulse in ihrer Intensität verringert oder ausgelöscht werden, während die elektromagnetischen Hochfrequenzpulse ohne Gegenfeld ungehindert zum Implantat passieren können;
c) sowohl die elektromagnetischen Hochfrequenzpulse als auch die magnetischen Gradientenfeldpulse jeweils in ihrer Intensität verringert oder ausgelöscht werden.

Bei einer weiteren vorteilhaften Ausführungsform des erfindungsgemäßen Verfahrens werden Feldpulse als Gegenfelder von MRT-Feldpulsen derart erzeugt, dass eine magnetresonanztomographische Bildgebung auch im Wirkbereich der Gegenfelder möglich ist.

Bei weiteren vorteilhaften Ausführungsformen des erfindungsgemäßen Verfahrens werden Feldpulse als Gegenfelder derart erzeugt, dass sie nur in einem Frequenzbereich oberhalb von 1 MHz oder alternativ in einem Frequenzbereich von maximal 1 MHz wirksam sind.

Des Weiteren erstreckt sich die Erfindung auf die Verwendung einer erfindungsgemäßen Vorrichtung zur Erzeugung von Gegenfeldern zur Abschirmung eines zumindest teilweise aus einem metallischen bzw. elektrisch leitfähigen Material bestehenden Implantats im Körper einer Person bei einer magnetresonanztomographischen Aufnahme.

Es versteht sich, dass die verschiedenen Ausführungsformen und Ausgestaltungen der erfindungsgemäßen Gegenstände einzeln oder in beliebigen Kombinationen realisiert sein können. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird nun anhand von Ausführungsbeispielen näher erläutert, wobei Bezug auf die beigefügten Zeichnungen genommen wird. Gleiche bzw. gleich wirkende Elemente sind mit denselben Bezugszahlen bezeichnet. Es zeigen:
- Fig. 1: einen typischer Temperaturverlauf der Elektrodenspitze einer implantierten Elektrode bei einer MRT-Untersuchung;
- Fig. 2A-2B: schematische Darstellungen eines Patienten mit Implantat ohne Vorrichtung zur Erzeugung von Gegenfeldern (Fig. 2A) und mit einer beispielhaften Vorrichtung zur Erzeugung von Gegenfeldern (Fig. 2B);
- Fig. 3: eine schematische Darstellung eines Patienten mit Implantat zur Veranschaulichung einer weiteren beispielhaften Vorrichtung zur Erzeugung von Gegenfeldern;
- Fig. 4A-4B: schematische Darstellungen zur Veranschaulichung einer beispielhaften Abschirmanordnung;
- Fig. 5A-5B: rechnerische Simulationen zur Veranschaulichung der Wirkung der Vorrichtung zur Erzeugung von Gegenfeldern;
- Fig. 6A-6B: weitere rechnerische Simulationen zur Veranschaulichung der Wirkung der Vorrichtung zur Erzeugung von Gegenfeldern;
- Fig. 7: eine schematische Darstellung des Aufbaus einer beispielhaften Vorrichtung zur Erzeugung von Gegenfeldern;
- Fig. 8: eine schematische Darstellung zur Veranschaulichung der Vermeidung von elektromagnetischer Interferenz eines MRT-Feldpulses mit einer Programmierspule eines Implantats;
- Fig. 9: eine schematische Darstellung zur Veranschaulichung der Verwendung der Vorrichtung zur Erzeugung von Gegenfeldern als Link zwischen einem Programmiergerät und einem elektronischen Implantat;
- Fig. 10: den beispielhaften Verlauf des B1-Felds bei einer MRT-Untersuchung mit und ohne Vorrichtung zur Erzeugung von Gegenfeldern.

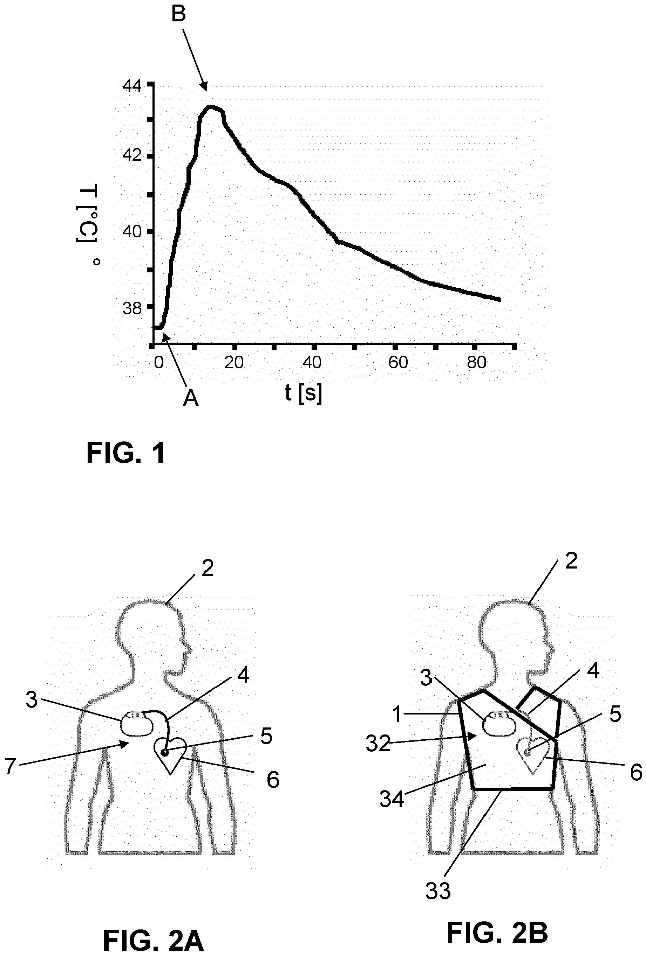

Sei zunächst Fig. 1 betrachtet, worin anhand eines Diagramms ein typischer Temperaturverlauf der Elektrodenspitze einer implantierten konventionellen Schrittmacher/ICD-Elektrode bei einer MRT-Untersuchung dargestellt ist. Als Abszisse ist die Zeit (t) in Sekunden und als Ordinate die Temperatur T in °C aufgetragen. Ursache für die Temperaturerhöhung ist eine elektromagnetische Interferenz (Erzeugung von Induktionsströmen) zwischen den MRT-Feldpulsen und der Elektrode.

Demnach steigt die Temperatur der Elektrodenspitze mit Einschalten des hochfrequenten Wechselfelds zum Zeitpunkt A rasch an, wobei die Steilheit des Temperaturanstiegs und die maximal erreichbare Temperatur stark von der räumlichen Lage der Elektrode bezüglich des Wechselfelds abhängt. Im gezeigten Beispiel steigt die Temperatur bis über 43°C an. Nach Abschalten des Wechselfelds zum Zeitpunkt B kühlt sich die Elektrodenspitze aufgrund der relativ geringen Wärmekapazität verhältnismäßig schnell wieder ab. Durch die erreichte hohe Temperatur der Elektrodenspitze kann eine thermische Schädigung des umliegenden Gewebes nicht ausgeschlossen werden.

In den Figuren 2A und 2B ist anhand schematischer Darstellungen ein Patient 2 mit einem hier beispielsweise als Schrittmacher 3 ausgeführten elektronischen Implantat gezeigt. Fig. 2A zeigt den Patienten 2 ohne erfindungsgemäße Vorrichtung 1 zur Erzeugung von Gegenfeldern und Fig. 2B den Patienten 2 mit angelegter Vorrichtung 1 zur Erzeugung von Gegenfeldern. Der Schrittmacher 3 ist über eine Elektrodenleitung 4 mit dem Herzen 6 des Patienten verbunden. Die Elektrodenleitung 4 verfügt zu diesem Zweck über einen distalen Abschnitt, welcher beispielsweise den rechten Herzvorhof passiert und mit einem distalen Ende bzw. Elektrodenspitze 5 innerhalb der rechten Herzkammer positioniert ist. Nicht näher dargestellte Elektrodenflächen im Bereich der Elektrodenspitze 5 können für Abtast-und/oder Stimulationszwecke (antibradykarde Stimulation) verwendet werden. Der Schrittmacher 3 kann elektrische Signale des Herzens 6 erfassen und elektrische Impulse abgeben, um je nach Bedarf Kontraktionen auszulösen. Anstelle eines Schrittmachers 3 könnte gleichermaßen beispielsweise ein ICD (Kardioverter/Defibrillator) implantiert sein. Hierbei handelt es sich um ein elektronisches Gerät, welches Schockimpulse erzeugen kann, beispielsweise um ein lebensbedrohliches Kammerflimmern zu beenden

Ohne entsprechende Gegenmaßnahmen besteht bei einer MRT-Untersuchung vor allem für die kleinflächige Elektrodenspitze 5 die Gefahr einer Erwärmung durch die Erzeugung von Induktionsströmen durch die eingesetzten hochfrequenten Wechselfelder mit der möglichen Folge einer Schädigung des umliegenden Gewebes. Die elektromagnetische Interferenz kann gegebenenfalls auch zu einem Anstieg der Stimulationsreizschwellen und einer Beeinträchtigung der Wahrnehmungsfunktion (Fehl- bzw. Oversensing) des Schrittmachers 3 führen. Dabei kann nicht ausgeschlossen werden, dass der Schrittmacher 3 falsch therapiert bzw. eine Therapie inhibiert wird.

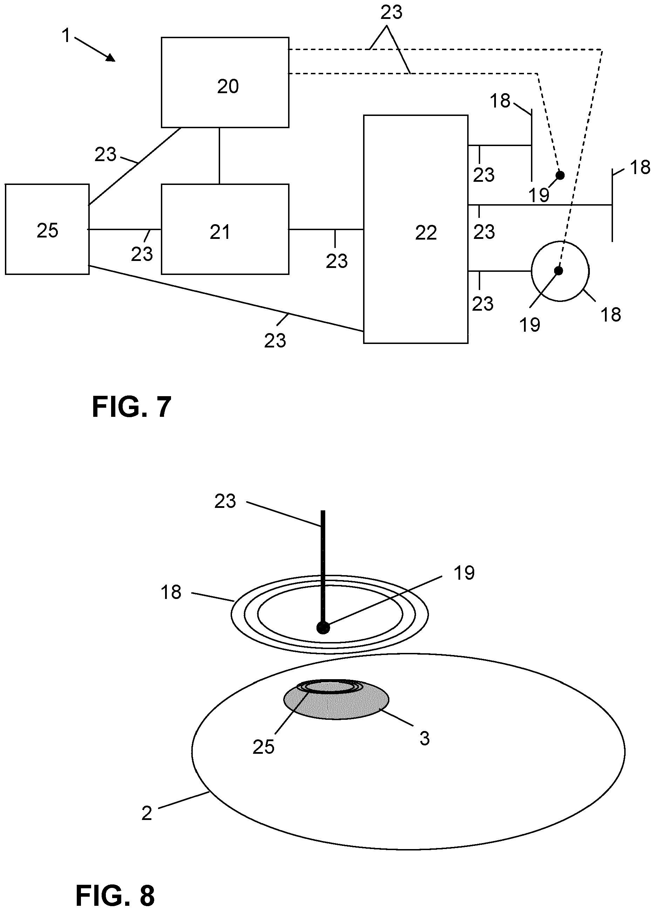

Diese unerwünschten Folgen können durch die in Fig. 2B gezeigte Vorrichtung 1 zur Erzeugung von Gegenfeldern vermieden werden. Die Vorrichtung 1 ist hier beispielsweise in Form einer Weste ausgebildet, die im Bereich des Thorax 7 des Patienten 2 als wickelbares Teil einfach und sicher für den Zeitraum der MRT-Untersuchung anlegbar ist. Die Vorrichtung 1 zur Erzeugung von Gegenfeldern deckt den Bereich des implantierten Schrittmachers 3 und der zugehörigen Elektrodenleitung 4 um den Patienten 2 herum vollständig ab und schirmt die implantierten Komponenten in einer diese enthaltenden räumlichen Zone 32 ab. Eine Befestigung der Vorrichtung 1 zur Erzeugung von Gegenfeldern am Patienten 2 kann beispielsweise durch einen Klettverschluss erfolgen, was nicht näher dargestellt ist. Alternativ wäre es gleichermaßen möglich, dass die Vorrichtung 1 zur Erzeugung von Gegenfeldern beispielsweise als eine Art Bandage oder als aufklebbarer Einmalartikel ausgebildet ist. Durch die Vorrichtung 1 zur Erzeugung von Gegenfeldern können der Schrittmacher 3 und die Elektrodenleitung 4 vor den bei der MRT-Untersuchung eingesetzten MRT-Feldpulsen in einem nennenswerten Umfang oder völlig abgeschirmt werden. Wie in Fig. 7 veranschaulicht ist, umfasst die Vorrichtung 1 zur Erzeugung von Gegenfeldern zu diesem Zweck eine insgesamt mit der Bezugszahl 10 bezeichnete Felderzeugungseinrichtung 10, welche über eine Mehrzahl Felderzeugungsmittel 18 zur Erzeugung elektromagnetischer Wechselfelder, die hier beispielsweise als Antennen ausgebildet sind, verfügt. Sensoren 19 dienen zur Erfassung der MRT-Feldpulse in Nähe des abzuschirmenden Schrittmachers 3 und Elektrodenleitung 4. Eine Steuereinrichtung 20 zur Steuerung der Vorrichtung 1 zur Erzeugung von Gegenfeldern ist durch elektrische Leitungen 23 mit den Sensoren 19 und unter Zwischenschaltung eines Signalgenerators 21 und eines Verstärkers 22 mit den Felderzeugungsmitteln 18 datentechnisch verbunden. Die Vorrichtung 1 kann somit auf Basis von Sensorsignalen der Sensoren 19, die ausgelesen und verarbeitet werden, durch den Signalgenerator 21 Antennensignale erzeugen, die unter Verstärkung durch den Verstärker 22 (mit Treiber und Anpassnetzwerk) an die Felderzeugungsmittel 18 zur Erzeugung elektromagnetischer Wechselfelder übertragen werden. Ein mit der Steuereinrichtung 20, dem Signalgenerator 21 und dem Verstärker 22 datentechnisch verbundener externer Controller 25 dient zur externen Steuerung der Vorrichtung 1.

Wie in Fig. 2B veranschaulicht, ist die Vorrichtung 1 zur Erzeugung von Gegenfeldern beispielsweise in Form einer am Thorax 7 angebrachten Weste ausgebildet, wobei die Weste der Kontur der Körperoberfläche des Patienten 2 in einfacher Weise angepasst werden kann. Die Vorrichtung 1 weist eine relative magnetische Permeabilität von maximal 100, insbesondere maximal 4 auf, insbesondere maximal 1 auf, so dass es für die in der MRT-Untersuchung verwendeten starken statischen Magnetfelder und ― falls keine aktive Abschirmung erfolgt - für die dabei eingesetzten magnetischen Gradientenfelder transparent ist. Ein Randbereich 33 der Vorrichtung 1 zur Erzeugung von Gegenfeldern ist so ausgebildet, dass sich eine Wellenimpedanz der insbesondere hochfrequenten MRT-Feldpulse vom nicht-abgeschirmten Körpergewebe zum abgeschirmten Bereich hin nur geringfügig ändert. Zudem ist die Vorrichtung 1 so eingerichtet, dass der Randbereich 33 in Bezug auf einen innerhalb des Randbereichs angeordneten Innenbereich 34, eine verminderte Intensitätsverringerung von bei der magnetresonanztomographischen Aufnahme eingesetzten Feldpulsen aufweist.

Durch die Vorrichtung 1 können Feldpulse erzeugt werden, die als Gegenfelder zur aktiven (unter Energieverbrauch) Kompensation der bei der magnetresonanztomographischen Aufnahme eingesetzten MRT-Feldpulse dienen und damit den Schrittmacher 3 und die Elektrodenleitung 4 schützen. Der Schrittmacher 3 und die Elektrodenleitung 4 sind somit zumindest annähernd feldfrei oder die anliegenden Felder führen zu keiner schädigenden Wirkung für Schrittmacher 3 und Patient 2. Vorteilhaft werden Gegenfelder nur während einer Anregungsphase erzeugt, so dass die während einer Auslesephase durch die relaxierenden Atomkerne ausgesandten elektromagnetischen Wechselfelder vom Magnetresonanztomographen zur Bildgebung ohne Beeinträchtigung durch die Gegenfelder erfasst werden können. Weiterhin ist es von Vorteil, wenn die Vorrichtung 1 über eine (nicht dargestellte) Kühleinrichtung zu deren aktiven oder passiven Kühlung verfügt, um den Patientenkomfort zu verbessern und eine übermäßige Erwärmung bei länger dauernden MRT-Untersuchungen zu vermeiden. Eine passive Kühlung kann beispielsweise durch Kühlakkus erreicht werden.

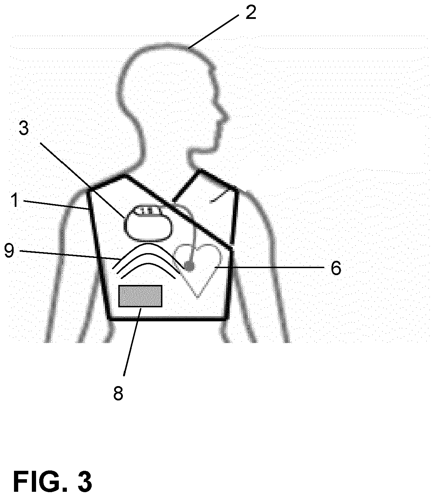

Fig. 3 zeigt eine Variante, bei der die als Weste ausgebildete Vorrichtung 1 zur Erzeugung von Gegenfeldern mit einer Kommunikationseinrichtung 8 versehen ist. Die Kommunikationseinrichtung 8 ist in der Lage, ein elektrisches Signal 9 drahtlos an den Schrittmacher 3 zu senden, wobei auf diese Weise die Information übermittelt werden kann, dass die Vorrichtung 1 verwendet und eine MRT-Untersuchung durchgeführt wird. Der Schrittmacher 3 kann beispielsweise so programmiert sein, dass es daraufhin in einen MRT-Betriebsmodus schaltet, der zur Vermeidung von Fehlfunktionen an die MRT-Untersuchung speziell angepasst ist. Die Kommunikationseinrichtung 8 verfügt zu diesem Zweck über nicht näher dargestellte Mittel zur Erkennung eines statischen Magnetfelds und/oder Gradientenfelds und/oder elektromagnetischen Hochfrequenzfelds, sowie über Mittel zum Erzeugen und Senden der Signale 9, die vorzugsweise eine vom Schrittmacher 3 erkennbare Kodierung aufweisen, um diesen vorzugsweise temporär in den MRT-Betriebsmodus zu versetzen. Die Kommunikationseinrichtung 8 kann die benötigte Energie beispielsweise aus den bei der MRT-Untersuchung eingesetzten Feldern beziehen, wobei sie zu diesem Zweck über nicht näher dargestellte Mittel zur Energiegewinnung und Energiezwischenspeicherung (z. B. Kondensator, Akkumulator) verfügt. Die Aktivität der Kommunikationseinrichtung 8 wird somit ausschließlich durch externe Energie gesteuert, wobei der Schrittmacher 3 bei fehlender Aktivität der Kommunikationseinrichtung 8 die Information erhält, dass die Bildgebung bzw. das Erzeugen hochfrequenter Wechselfelder beendet ist und somit wieder in den normalen Betriebsmodus schalten kann. Alternativ wäre es auch möglich, dass die Kommunikationseinrichtung 8 durch einen eigenen Energiespeicher (Batterie) versorgt wird. Insbesondere kann eine Antenne der Felderzeugungsmittel 18 zur Kommunikation mit dem Schrittmacher 3 und der Vorrichtung 1 eingesetzt werden

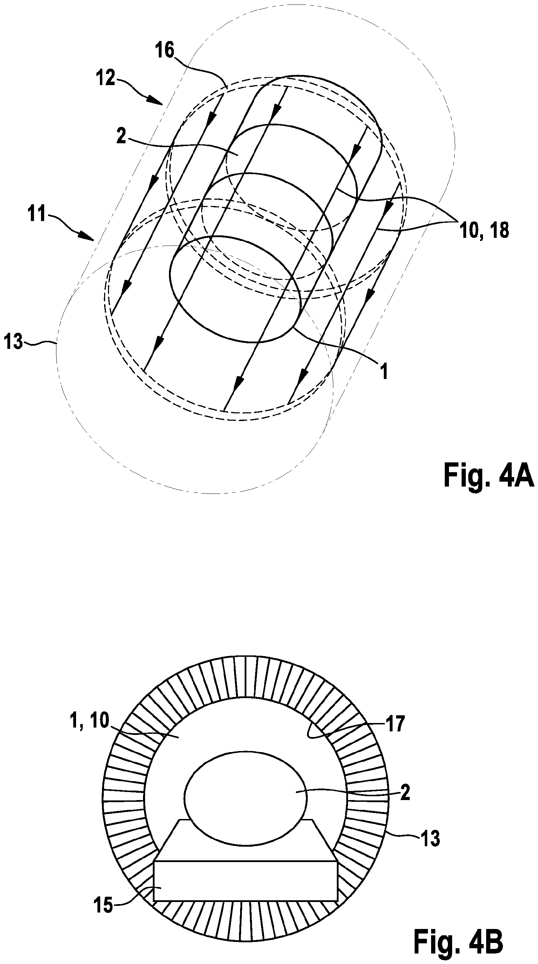

In den Figuren 4A und 4B ist ein weiteres Ausführungsbeispiel der Erfindung in schematischer Weise veranschaulicht. Fig. 4A zeigt eine (transparente) perspektivische Darstellung, Fig. 4B einen Vertikalschnitt durch Fig. 4A. Demnach umfasst eine insgesamt mit der Bezugszahl 11 bezeichnete Abschirmanordnung einen Magnetresonanztomographen 12 mit einer röhrenförmigen Aufnahme bzw. Patientenzylinder 13, in dem ein schematisch dargestellter Patient 2 auf einer Patientenliege 15 zur Untersuchung zu platzieren ist. Mittels eines zylindrischen Hochfrequenzresonators 16 kann für die MRT-Untersuchung ein elektromagnetisches Wechselfeld erzeugt werden. Dabei dient der Patientenzylinder 13 zur Abschirmung der Wechselfelder nach außen hin. Am Körper des Patienten 2 ist eine Vorrichtung 1 zur Erzeugung von Gegenfeldern angeordnet, die wie in den zuvor erläuterten Ausführungsbeispielen beispielsweise als Weste zur Abschirmung eines Implantats im thorakalen Bereich ausgebildet sein kann. Insbesondere kann sie eine Anordnung von als Antennen ausgebildeten Felderzeugungsmitteln 18 umfassen, die im Umfeld des zu schützenden Körperbereichs, insbesondere um den Körper herum, angeordnet sind. Durch die räumlich versetzbare (höheneinstellbare) Patientenliege 15 (z.B. Luftbett) kann der Patient 2 innerhalb des Patientenzylinders 13 wahlfrei in eine gewünschte Position gebracht werden, beispielsweise zentriert innerhalb der Vorrichtung 1. In der Felderzeugungseinrichtung 10 sind die Antennen entlang einer zylindrischen Kontur angeordnet, die hier beispielsweise koaxial zum Hochfrequenzresonator 16 angeordnet ist, wodurch ein besonders guter Abschirmeffekt erzielt werden kann.

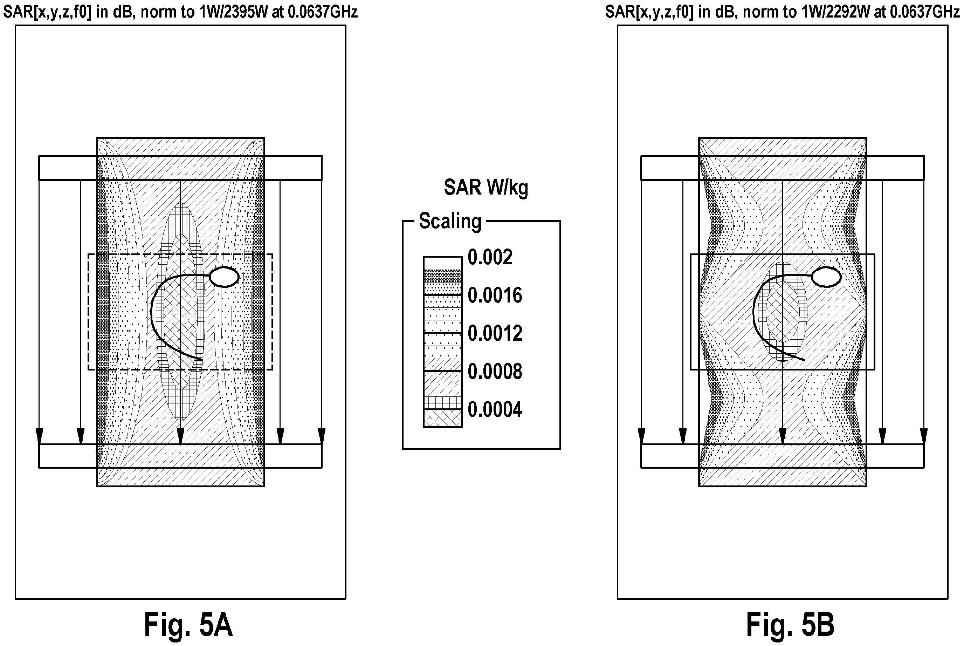

Für eine Situation, wie sie in den Figuren 4A und 4B gezeigt ist, ist in den Figuren 5A und 5B eine Verteilung der im Körper des Patienten 2 im Bereich der Elektrodenleitung 4 bei der MRT-Untersuchung erzeugten Energiedichten (SAR = spezifische Absorptionsrate) in W/kg dargestellt, wobei Figur 5A die Situation ohne Vorrichtung 1 zur Erzeugung von Gegenfeldern und Figur 5B die Situation mit Vorrichtung 1 zeigt. Diese basieren auf einer rechnerischen Simulation, bei der der Patient 2 zentral im Scanner bzw. Patientenzylinder 13 liegt (worst case scenario). Durch die Abbildungen wird klar erkennbar, welche Energiedichten in der unmittelbaren Umgebung der Elektrodenleitung 4 vorliegen und welcher vorteilhafte Effekt dabei durch die Vorrichtung 1 zur Erzeugung von Gegenfeldern erreicht werden kann.

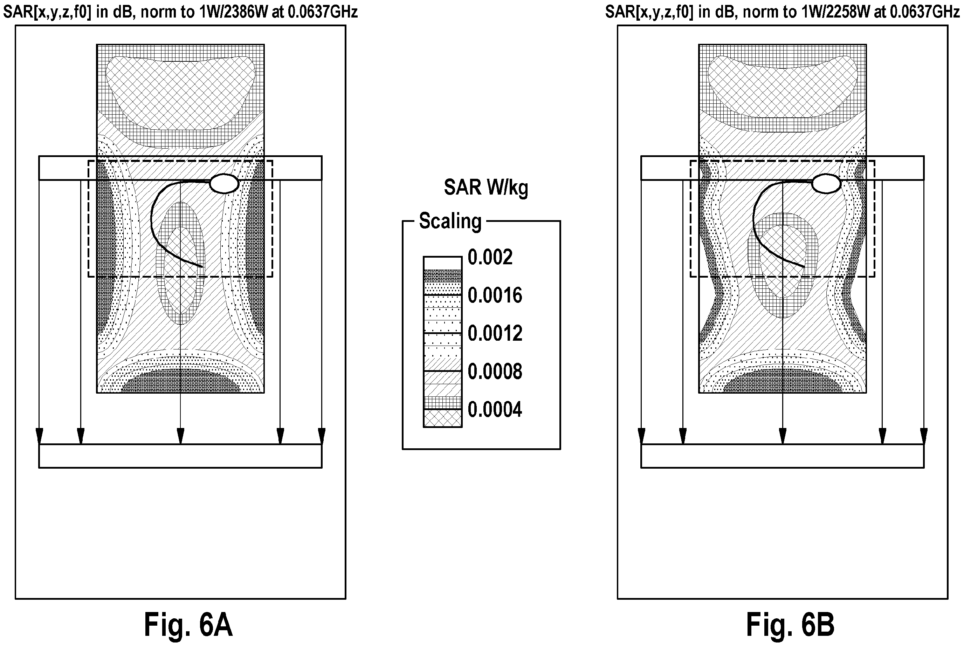

Für eine Situation, wie sie in den Figuren 4A und 4B gezeigt ist, ist in den Figuren 6A und 6B eine Verteilung der im Körper des Patienten 2 im Bereich der Elektrodenleitung 4 bei der MRT-Untersuchung erzeugten Energiedichten (SAR = spezifische Absorptionsrate) in W/kg dargestellt, wobei Figur 6A die Situation ohne Vorrichtung 1 und Figur 6B die Situation mit Vorrichtung 1 zeigt. Diese basieren auf einer rechnerischen Simulation, bei der der Patient 2 dezentral im Scanner bzw. Patientenzylinder 13 liegt (Abdomen-Scan). Auch durch diese Abbildungen wird klar erkennbar, welche Energiedichten in der unmittelbaren Umgebung der Elektrodenleitung 4 vorliegen und welcher vorteilhafte Effekt dabei durch die Vorrichtung 1 erreicht werden kann.

Fig. 8 veranschaulicht die Vermeidung elektromagnetischer Interferenz zwischen einem MRT-Feldpuls und einer Programmierspule 25 des Schrittmachers 3 im Körper des Patienten 2. Die Programmierspule 25 ist besonders sensitiv auf die Erzeugung von Induktionsströmen durch magnetische Gradientenfelder. Das Felderzeugungsmittel 18, das als Spule oder Antenne ausgebildet ist, erzeugt ein dem Störfeld entgegenwirkendes Feld, das so optimiert wird, bis der Sensor 19 ein Minimum für das Gesamtfeld an dieser Stelle angibt. Eine Optimierung des Gegenfelds kann über eine Variation von Amplitude, Phase, Frequenz, Ein-/Ausschaltzeit und Flankensteilheit erfolgen.

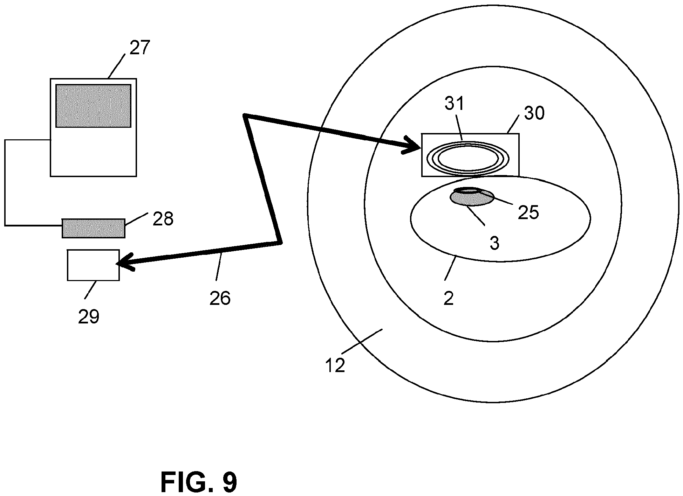

Fig. 9 veranschaulicht die Verwendung der Vorrichtung 1 zur Erzeugung von Gegenfeldern als Link zwischen einem (außerhalb des Magnetresonanztomographen 12) angeordneten Programmiergerät 27 zur Programmierung des Schrittmachers 3 und dem Schrittmacher 3. Demnach umfasst das Programmiergerät 27 einen Programmierkopf 28, sowie einen ersten Wandler 29, der über eine vorzugsweise bidirektionale Datenleitung 26 mit einem zweiten Wandler 30 der Vorrichtung 1 zur Erzeugung von Gegenfeldern verbunden ist. Der zweite Wandler 30 ist mit einer Antenne 31 zur Kommunikation mit der Programmierspule 25 des Schrittmachers 3 versehen. Bei der Antenne 31 kann es sich insbesondere um ein Felderzeugungsmittel 18, d. h., um eine Antenne zur Erzeugung von Gegenfeldern, handeln. Die Datenleitung 26 kann eine drahtgebundene oder drahtlose Kommunikation ermöglichen. Eine Kommunikation zwischen dem Programmiergerät 27 und dem Schrittmacher 3 erfolgt vorzugsweise auf Frequenzen, welche eine MRT-Aufnahme nicht beeinträchtigen. Die Kommunikation kann insbesondere durch optische und/oder akustische Signalgebung erfolgen. Durch die Verwendung der Vorrichtung 1 zur Erzeugung von Gegenfeldern als Link kann während einer MRT-Untersuchung eine Programmierung des Schrittmachers 3 vorgenommen werden.

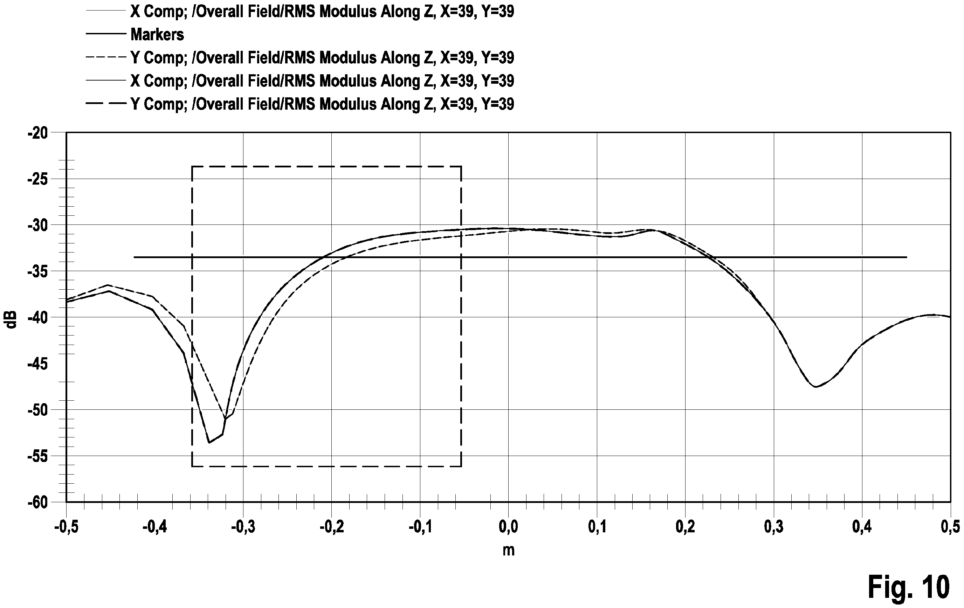

Fig. 10 illustriert die Bildgebungsmöglichkeiten bei Einsatz der erfindungsgemäßen Vorrichtung 1 zur Erzeugung von Gegenfeldern bei einer MRT-Untersuchung. Als Abszisse ist der Ort in Meter (m), als Ordinate der Feldstärkepegel dB der x- und y-Komponenten des B₁-Felds angegeben. Die Kurve I illustriert eine Situation ohne Abschirmvorrichtung, die Kurve II mit Abschirmvorrichtung. Oberhalb der Kurve III reicht die Feldstärke des B₁-Felds für Bildgebung aus. Die gestrichelte Linie gibt den Bereich der Abschirmung an. Demnach bleibt das B₁-Feld auch im Falle einer Gegenfeldwirkung zirkular polarisiert, d. h. die x- und y-Komponenten sind gleich stark, und wird nur lokal gedämpft. Es wird lediglich das Gesichtsfeld (FOV = field of view) gering eingeschränkt. Hieraus kann geschlossen werden, dass mit der Vorrichtung 1 zur Erzeugung von Gegenfeldern eine Bildgebung sogar bis innerhalb des geschützten Bereichs möglich ist.

Wie anhand der Ausführungsbeispiele ausführlich erläutert ist, ermöglicht die vorliegende Erfindung eine einfache, kostengünstige und für den Patienten gefährdungsfreie MRT-Untersuchung, ohne dass spezielle Vorkehrungen am Implantat zu treffen sind. Insbesondere können auch Patienten, die bereits ein Implantat besitzen, einer MRT-Untersuchung unterzogen werden, wobei keine besonderen Einstellungen am Magnetresonanztomographen erforderlich sind. Ein besonderer Vorteil besteht in der Möglichkeit auch defekte oder stillgelegte Sonden und lange Stents wie Gefäßprothesen abzuschirmen.

### Bezugszeichenliste

- 1: Vorrichtung zur Erzeugung von Gegenfeldern
- 2: Patient
- 3: Schrittmacher
- 4: Elektrodenleitung
- 5: Elektrodenspitze
- 6: Herz
- 7: Thorax
- 8: Kommunikationseinrichtung
- 9: Signal
- 10: Felderzeugungseinrichtung
- 11: Abschirmanordnung
- 12: Magnetresonanztomograph
- 13: Patientenzylinder
- 14: Raum
- 15: Patientenliege
- 16: Hochfrequenzresonator
- 17: Innenwand
- 18: Felderzeugungsmittel
- 19: Sensoren
- 20: Steuereinrichtung
- 21: Signalgenerator
- 22: Verstärker
- 23: Leitung
- 24: Controller
- 25: Programmierspule
- 26: Datenleitung
- 27: Programmiergerät
- 28: Programmierkopf
- 29: erster Wandler
- 30: zweiter Wandler
- 31: Antenne
- 32: Zone
- 33: Randbereich
- 34: Innenbereich

## Patentansprüche

1. Vorrichtung (1) zur Erzeugung von Gegenfeldern zur Abschirmung eines Implantats (3, 4) im Körper einer Person (2) bei einer magnetresonanztomographischen Aufnahme, welche eine Felderzeugungseinrichtung (10) mit einem oder mehreren Felderzeugungsmitteln (18) zum Erzeugen von Feldpulsen und eine mit der Felderzeugungseinrichtung (10) gekoppelte Steuereinrichtung (20) umfasst und so ausgebildet ist, dass Feldpulse als Gegenfelder erzeugbar sind, durch welche bei der magnetresonanztomographischen Aufnahme eingesetzte hochfrequente, elektromagnetische Feldpulse und/oder magnetische Gradientenfeldpulse in einer das Implantat (3, 4) zumindest abschnittsweise enthaltenden räumlichen Zone (32) durch Superposition in ihrer Intensität verringer- oder auslöschbar sind.

2. Vorrichtung (1) nach Anspruch 1, **dadurch gekennzeichnet, dass** sie einen oder mehrere Sensoren (19) zum Erfassen von bei der magnetresonanztomographischen Aufnahme eingesetzten hochfrequenten, elektromagnetischen Feldpulsen und/oder magnetischen Gradientenfeldpulsen und Erzeugen entsprechender Sensorsignale umfasst und so ausgebildet ist, dass Gegenfelder auf Basis von Sensorsignalen erzeugbar sind.

3. Vorrichtung (1) nach einem der Ansprüche 1 oder 2, **dadurch gekennzeichnet, dass** zumindest die Felderzeugungseinrichtung (10) vorübergehend am oder nahe dem Körper der Person (2) angeordnet werden kann.

4. Vorrichtung (1) nach Anspruch 3, **dadurch gekennzeichnet, dass** zumindest die Felderzeugungseinrichtung (10) zur Anpassung an eine Kontur einer Körperoberfläche der Person (2) geeignet ausgebildet ist.

5. Vorrichtung (1) nach einem der Ansprüche 1 bis 4, bei welcher zumindest die Felderzeugungseinrichtung (10) mit dem Körper der Person (2) galvanisch und/oder kapazitiv koppelbar ist.

6. Vorrichtung (1) nach einem der Ansprüche 1 bis 5, welche mit einer Kommunikationseinrichtung (8) zur Kommunikation mit dem Implantat (3) versehen ist.

7. Vorrichtung (1) nach einem der Ansprüche 1 bis 6, welche eine Markierungseinrichtung zur Markierung der das Implantat (3, 4) enthaltenden räumlichen Zone (32) in einer magnetresonanztomographischen Aufnahme aufweist.

8. Vorrichtung (1) nach einem der Ansprüche 1 bis 7, welche eine Energieerzeugungseinrichtung zur Erzeugung von Energie aus bei der magnetresonanztomographischen Aufnahme eingesetzten Feldpulsen aufweist.

9. Vorrichtung (1) nach einem der Ansprüche 1 bis 8, welche so ausgebildet ist, dass ein Randbereich (33), insbesondere ein Randbereich der Felderzeugungseinrichtung (10), in Bezug auf einen innerhalb des Randbereichs angeordneten Innenbereich (34), eine verminderte Intensitätsverringerung von bei der magnetresonanztomographischen Aufnahme eingesetzten Feldpulsen aufweist.

10. Verfahren zum Betreiben eines Magnetresonanztomographen, bei welchem Feldpulse als Gegenfelder durch eine Vorrichtung zur Erzeugung von Gegenfeldern, welche eine Felderzeugungseinrichtung mit mindestens einem Felderzeugungsmittel zur Erzeugung von Feldpulsen umfasst, erzeugt werden, durch welche bei einer magnetresonanztomographischen Aufnahme eingesetzte hochfrequente, elektromagnetische Feldpulse und/oder magnetische Gradientenfeldpulse in einer ein Implantat im Körper einer Person zumindest abschnittsweise enthaltenden räumlichen Zone durch Superposition in ihrer Intensität verringer- oder auslöschbar sind.

11. Verfahren nach Anspruch 10, bei welchem die Vorrichtung zur Erzeugung von Gegenfeldern, insbesondere die Felderzeugungseinrichtung zur Erzeugung von Feldpulsen, am oder nahe dem Körper der Person angebracht wird.

12. Verfahren nach einem der Ansprüche 10 oder 11, bei welchem bei einer magnetresonanztomographischen Aufnahme eingesetzte Feldpulse durch zumindest einen Sensor erfasst und Feldpulse als Gegenfelder auf Basis von Sensorsignalen erzeugt werden.

13. Verfahren nach einem der Ansprüche 10 bis 12, bei welchem Gegenfelder derart erzeugt werden, dass bei einer magnetresonanztomographischen Aufnahme eingesetzte Feldpulse während einer Anregungsphase in ihrer Intensität verringert oder ausgelöscht werden und während einer Auslesephase in ihrer Intensität zumindest schwächer verringert werden.

14. Verfahren nach einem der Ansprüche 10 bis 13, bei welchem die Intensität von bei der magnetresonanztomographischen Aufnahme eingesetzten Feldpulsen so verringert wird, dass eine magnetresonanztomographische Aufnahme in der das Implantat enthaltenden räumlichen Zone zumindest bereichsweise möglich ist.

15. Verfahren nach einem der Ansprüche 10 bis 14, **dadurch gekennzeichnet, dass** das Implantat vor und/oder während einer magnetresonanztomographischen Aufnahme in einen spezifisch angepassten Betriebsmodus versetzt wird.
